# EUROPEAN PATENT APPLICATION

(11) **EP 2 395 825 A2**
(43) Date of publication of application: **14.12.2011**
(21) Application number: 10187990.6
(22) Date of filing: 19.10.2010
(51) Int. Cl.: H05K 5/02

(54) **Cover structure of electronic apparatus**

(30) Priority: 08.06.2010 TW 099118475
(71) Applicant: Ability Enterprise Co., Ltd., Taipei (TW)
(72) Inventor: Lin, Yu-Fang, Taipei (TW); Lee, Hsien-Ming, Taipei (TW); Wu, Tzu-Peng, Taipei County (TW)
(74) Representative: Karakatsanis, Georgios

(57) **Abstract**

A cover structure of an electronic apparatus is provided. The cover structure comprises a cover and a plate spring. The cover has a pivot having a cam at one end, wherein two ends of the penetrate portions of a case on the electronic apparatus respectively. The plate spring is located inside the case and contacts the cam. When the cover is forced to rotate, the cam drives the cover to rotate and open/close automatically by the elastic force of the plate spring.

## Description

### 1. Field of the Invention

The present invention relates to a cover structure of an electronic apparatus, and more particularly to a cover structure of an electronic apparatus which can open/close automatically while being applied a force.

### 2. Description of the Prior Art

Electronic products such as digital cameras or digital video cameras store data of digital pictures or digital images in memories or memory cards. In order to meet the requirements of replacing memory cards, data transfer or performing other functions, digital cameras or digital video cameras must be equipped with corresponding memory card sockets and/or universal serial bus sockets for data transfer. For the purpose of protecting the sockets from dust, the memory card socket and the universal serial bus port are equipped with covers to prevent the universal serial bus port from being exposed in possible contaminated environment or being damaged. In addition to the requirements mentioned above, there are further needs for the covers of digital cameras or digital video cameras including designed appearance, simple to manufacture and convenient to use for consumer, etc. Thus a simple cover structure is provided to meet these requirements.

### SUMMARY OF THE INVENTION

It is an object of the present invention is to provide a cover structure of an electronic apparatus which can open/close automatically when being applied a force.

According to the object of the present invention, one embodiment of the invention provides a cover structure of an electronic apparatus. The cover structure comprises a cover and a strip spring. The cover has a pivot with a cam on one end thereof, the two ends of the pivot penetrate into a portion of a case of the electronic apparatus. The strip spring is located inside the case such that the cam contacts the strip spring, and the cover rotates to automatically open or close by a recoil force from the strip spring when a force is applied upon the cover.

According to another object of the present invention, one embodiment of the invention provides a case structure of an electronic apparatus. The case structure comprises a case with an opening, a cover covering the opening and having a pivot with a cam on one end thereof, a strip spring located inside the case and a mounting base. The two ends of the pivot penetrate into a portion of the case of the electronic apparatus. The cam contacts the strip spring, and the cover rotates to automatically open or close by a recoil force from the strip spring when a force is applied upon the cover. The mounting base is located inside the case, and the strip spring is mounted on the mounting base.

### BRIEF DESCRIPTION OF THE DRAWINGS

The accompanying drawings illustrate various embodiments of the present invention and are a part of the specification. The illustrated embodiments are merely examples of the present invention and do not limit the scope of the invention.
Fig. 1, an exploded view of a partial structure of an electronic apparatus according to one embodiment of the invention.
Fig. 2 shows an enlarged view of a cover according to one embodiment of the invention.
Fig. 3 shows a cross sectional view of a portion of the electronic apparatus according to one embodiment of the invention.
Figs. 4A and 4B are schematic views showing automatic open and close of the cover structure of the electronic apparatus according to one embodiment of the invention.
Fig. 5 shows a cover structure with multiple stages according to one embodiment of the invention.
Fig. 6 shows three contact surfaces of cams against the strip spring according to embodiments of the invention.

### DESCRIPTION OF THE PREFERRED EMBODIMENT

The detailed description of the present invention will be discussed in the following embodiments, which are not intended to limit the scope of the present invention, but can be adapted for other applications. While drawings are illustrated in details, it is appreciated that the scale of each component may not be expressly exactly.

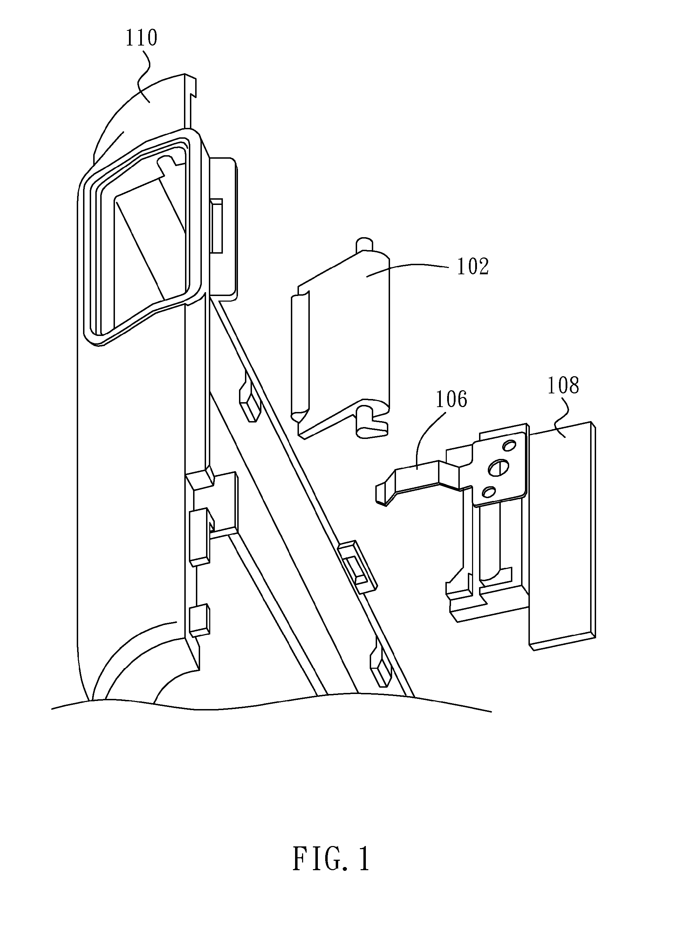

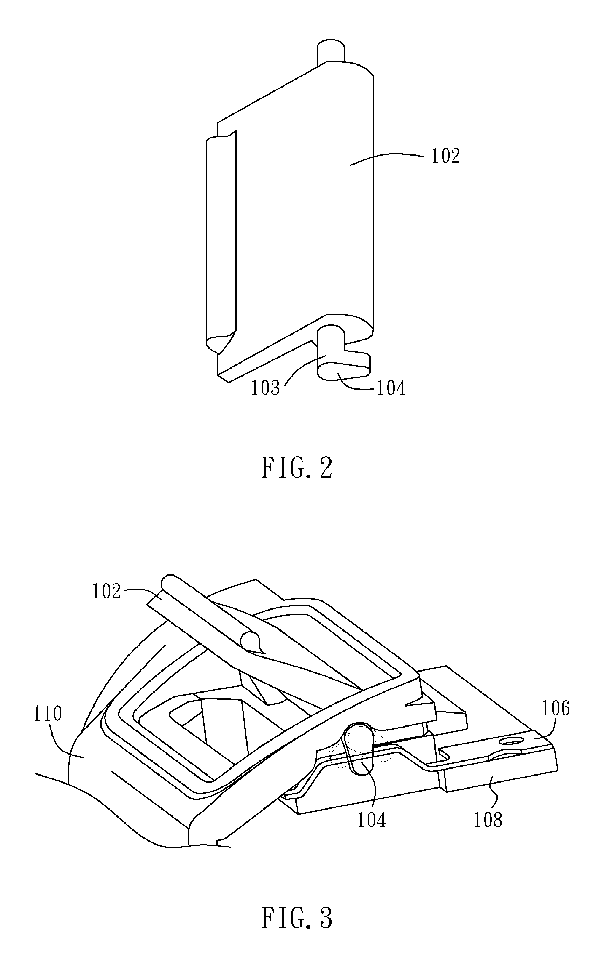

Referring to Fig. 1 , an exploded view of a partial structure of an electronic apparatus according to one embodiment of the invention. The electronic apparatus includes digital camera, but not limited to digital camera. Any electronic apparatus equipped with a cover such as digital video camera or cellular phone is also included. The structure of an electronic apparatus shown in Fig. 1 includes a cover 102, a strip spring 106, a mounting base 108 and a case 110. The case 110 has an opening for accommodating a memory socket, a universal serial bus socket for data transfer or for other applications. Fig. 2 shows an enlarged view of a cover according to one embodiment of the invention. The cover 102 for covering the opening has a pivot 103. The pivot 103 has a cam 14 at one end. The two ends of the pivot 103 penetrate into a portion of the case 110 so that the cover 102 can rotate and pivot on the pivot 103. The cover 102 includes a memory card slot cover and an input/output interface port cover, wherein the input/output interface comprises a universal serial bus. The strip spring 106 is located inside the case 110 such that the cam 14 of the pivot 103 contacts the strip spring 106. When a force is applied on the cover 102 to force the cover 102 rotating, the cam 14 of the pivot 103 presses the strip spring 106 and the strip spring 106 recoils to drive the cam 14 as well as the pivot 103 and the cover 102 to rotate and close or open automatically. The strip spring 106 includes a metal strip spring and a plastic strip spring. The mounting base 108 is located inside the case 110. It is noted that the embodiment of the electronic apparatus shown in Fig. 1 includes a schematic configuration only, and thus those features which are not crucial for one with ordinary skill in the art to make and use the invention are omitted. Those features of the electronic apparatus of the embodiment which are omitted can be practiced via any well-known prior art, and one with ordinary skill in the art can make and use the invention based on ordinary level of skill.

Fig. 3 shows a cross sectional view of a portion of the electronic apparatus according to one embodiment of the invention. The cam 104 of the cover 102 contacts the strip spring 106, which is mounted on the mounting base 108. The cam 104 of the cover 102 presses and deforms the strip spring 106 simultaneously causing a recoil or recovery force of the strip spring 106 against the cam 104. When a force is applied on the cover 102 to force the cover 102 rotate, the cam 14 deforms the trip spring 106 while the trip spring 106 drives the cam 14, and the recoil force of the trip spring 106 drives the cover 102 to continuously and automatically rotate to open or close the opening of the case 110.

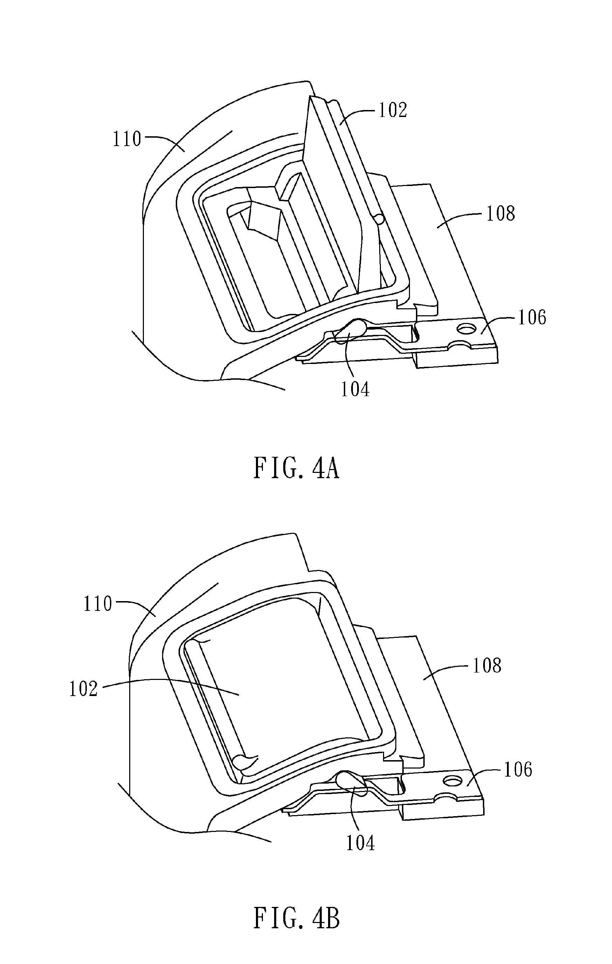

Figs. 4A and 4B are schematic views showing automatic open and close of the cover structure of the electronic apparatus according to one embodiment of the invention. In Fig. 4A, when the cover 102 is opened, the cover 102 will be opened automatically due to the recoil force from the strip spring 106 when the cover 102 is turned to a position over half of the entire route of the cover 102 toward the direction of open. In Fig. 4B, when the cover 102 is closed, the cover 102 will be closed automatically due to the recoil force from the strip spring 106 when the cover 102 is turned to a position over half of the entire route of the cover 102 toward the direction of close.

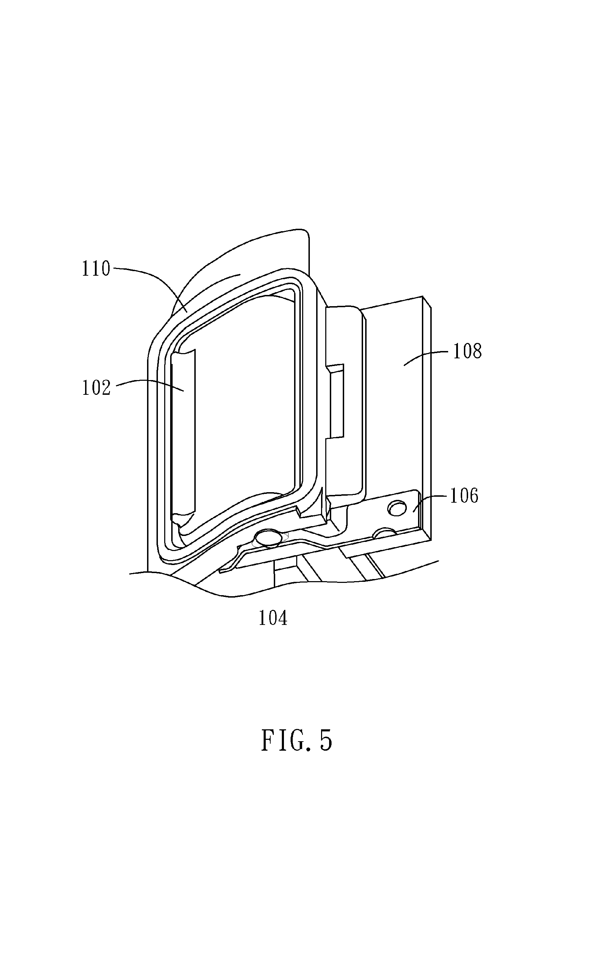

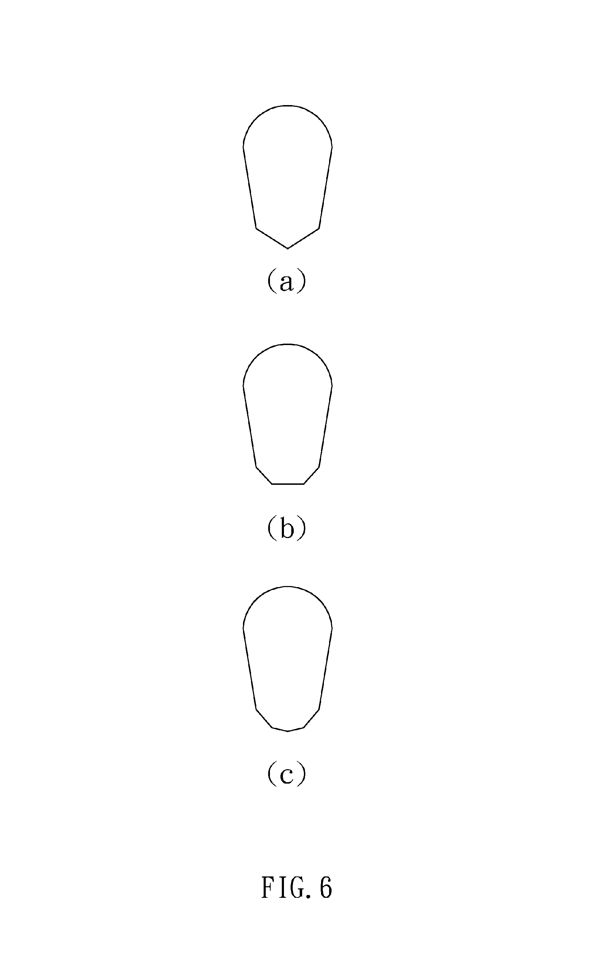

Fig. 5 shows a cover structure with multiple stages according to one embodiment of the invention. If the contact surface or cross section of the cam of the cover against the strip spring is polygon, or the contact surface of the cam 104 against the strip spring 106 includes a plurality of planes, the motions of open and close of the cover 102 will have multiple stages. Fig. 6 shows three contact surfaces of cams against the strip spring according to embodiments of the invention. As shown in Fig. 6 (a) to (c), the contact surface of the cam in (a) includes two planes and thus the cover can be rotated in two stages. The contact surface of the cam in (b) includes three planes and thus the cover can be rotated in three stages. The contact surface of the cam in (c) includes four planes and thus the cover can be rotated in four stages. It can be understood that if contact surface of the cam includes n planes and thus the cover can be rotated in n stages. When a force is applied upon the cover, the cover will rotate until the first plane of the contact surface of the cam completely attaches and contacts the strip spring and the cover stops rotating. The cover will rotate again if another force is applied upon the cover, and the second plane of the contact surface of the cam will contacts the strip spring until the second plane completely attaches and contacts the strip spring and the cover stops rotating again. Each plane of the contact surface of the cam corresponds to a stage of rotation, and thus more plane of the contact surface of the cam means more stage of rotation of the cover, and the cover will automatically complete the motions of open or close when the cover is rotated to a position where the last plane of the contact surface leaves the strip spring toward the direction of open or close. The polygonal surface or cross section of the cam can provide automatic motion of open or close of the cover.

The cover structure of the electronic apparatus of the invention uses a cam on one end of the pivot of the cover to interact with a spring located on the case of the electronic apparatus to generate the automatic motion of open or close of the cover. When a force is applied on the cover and the cover is forced to rotate, the cam rotates due to the recoil force from the spring or the principle of leverage, the cover can be opened and closed automatically. If the contact surface of the cam against the spring includes a polygonal surface, the motions of open or close of the cover will have multiple stages and automatic stop. The cover structure of the electronic apparatus of the invention uses a cam instead of conventional clutch hook or the like so that the scratch on the surface of the electronic apparatus resulting from the clutch hook can be prevented. The use of cam on the cover also has advantages of smaller size, succinct appearance and variety of design.

Although specific embodiments have been illustrated and described, it will be appreciated by those skilled in the art that various modifications may be made without departing from the scope of the present invention, which is intended to be limited solely by the appended claims.

## Claims

1. A cover structure of an electronic apparatus, the cover structure comprising:
a cover having a pivot with a cam on one end thereof, the two ends of the pivot penetrate into a portion of a case of the electronic apparatus; and
a strip spring located inside the case such that the cam contacts the strip spring, and the cover rotates to automatically open or close by a recoil force from the strip spring when a force is applied upon the cover.

2. The cover structure according to claim 1, wherein a contact surface of the cam against the strip spring includes a plurality of planes, when a force is applied upon the cover, the cover rotates until a first plane of the contact surface of the cam completely attaches and contacts the strip spring and the cover stops rotating; the cover rotates again if another force is applied upon the cover, and a second plane of the contact surface of the cam contacts the strip spring until the second plane completely attaches and contacts the strip spring and the cover stops rotating again.

3. The cover structure according to claim 2, wherein the contact surface of the cam has a plurality of planes for rotation in a plurality of stages.

4. The cover structure according to claim 1, wherein the electronic apparatus comprises a digital camera and a digital video camera.

5. The cover structure according to claim 1, wherein the cover comprises a memory card slot cover and an input/output interface port cover.

6. The cover structure according to claim 5, wherein the input/output interface comprises a universal serial bus.

7. A case structure of an electronic apparatus, the case structure comprising:
a case with an opening;
a cover covering the opening and having a pivot with a cam on one end thereof, the two ends of the pivot penetrating into a portion of the case of the electronic apparatus;
a strip spring located inside the case such that the cam contacts the strip spring, and the cover rotates to automatically open or close by a recoil force from the strip spring when a force is applied upon the cover; and
a mounting base located inside the case, and the strip spring mounting on the mounting base.

8. The case structure according to claim 7, wherein the strip spring comprises a metal strip spring and a plastic strip spring.

9. The case structure according to claim 7, wherein a contact surface of the cam against the strip spring includes a plurality of planes, when a force is applied upon the cover, the cover rotates until a first plane of the contact surface of the cam completely attaches and contacts the strip spring and the cover stops rotating; the cover rotates again if another force is applied upon the cover, and a second plane of the contact surface of the cam contacts the strip spring until the second plane completely attaches and contacts the strip spring and the cover stops rotating again.

10. The case structure according to claim 7, wherein the electronic apparatus comprises a digital camera and a digital video camera.
